# EUROPEAN PATENT APPLICATION

(11) **EP 3 503 221 A1**
(43) Date of publication of application: **26.06.2019**
(21) Application number: 18197118.5
(22) Date of filing: 27.09.2018
(51) Int. Cl.: H01L 31/18, H01L 31/0463, B23K 26/082, B23K 26/362, B23K 26/06, B23K 26/08, G02B 26/10

(54) **PROCESSING METHOD FOR REMOVING FILM AND APPARATUS FOR REMOVING FILM**

(30) Priority: 19.12.2017 CN 201711375583; 19.12.2017 CN 201711377087
(71) Applicant: Beijing Juntai Innovation Technology Co., Ltd, 100176 Beijing (CN)
(72) Inventor: HUANG, Tongyang, Beijing, 100176 (CN); XU, Xiaohua, Beijing, 100176 (CN); WANG, Xudong, Beijing, 100176 (CN); GUO, Zheng, Beijing, 100176 (CN); CAI, Cen, Beijing, 100176 (CN)
(74) Representative: Nordmeyer, Philipp Werner

(57) **Abstract**

Embodiments of the present disclosure provide a processing method for removing film and apparatus for removing film. The apparatus for removing film includes an optical component (31) and a processor (20), in which the optical component (31) includes: a laser generator (210) configured to generate a laser beam; a first scanning galvanometer (312a) configured to reflect the laser beam; and a second scanning galvanometer (312b) configured to reflect the laser beam reflected by the first scanning galvanometer (312a). The processor (20) is configured to control the laser generator (210) to generate a laser beam, and control the first scanning galvanometer (312a) and the second scanning galvanometer (312b) to deflect, thereby performing the film removal process on the target object (300').

## Description

The present application claims priority to the China Patent Application No. 201711375583.6, entitled "PROCESSING METHOD FOR REMOVING FILM AND APPARATUS FOR REMOVING FILM" filed on December 19, 2017 and No. 201711377087.4, entitled "PROCESSING METHOD FOR REMOVING FILM AND APPARATUS FOR REMOVING FILM" filed on December 19, 2017, the entire contents of which are incorporated herein by reference.

### FIELD OF THE INVENTION

The present disclosure relates to a photovoltaic technology, and more particularly to a processing method for removing film and apparatus for removing film.

### BACKGROUND

A film removal photovoltaic module is widely used because they can generate electricity and light, for example, it can be integrated with buildings, automobiles, etc., namely, a Building Integrated Photovoltaic (BIPV), and it can be attached to a building, namely, a Building Attached Photovoltaic (BAPV), and so on.

At present, the production of a film removal of a thin film solar cell is mostly achieved by laser engraving. In the related art, the laser film removal is generally performed by an engraved line method in which a motor drives a laser head, or an engraving line mode in which a cell sheet reciprocates in a case where the laser beam is not moved.

### SUMMARY

In one aspect, some embodiments of the present disclosure provide an apparatus for removing film comprising an optical component and a processor, wherein the optical component includes: a laser generator configured to generate a laser beam; a first scanning galvanometer configured to reflect the laser beam; and a second scanning galvanometer configured to reflect the laser beam reflected by the first scanning galvanometer; wherein the processor is configured to control the laser generator to generate the laser beam, and to control the first scanning galvanometer and the second scanning galvanometer to deflect, thereby performing a film removal process on a target object.

In another aspect, some embodiments of the present disclosure provide a processing method for removing film applying the apparatus for removing film of the first aspect. The method comprising: controlling the laser generator to generate a laser beam, and controlling the first scanning galvanometer and the second scanning galvanometer to deflect, so that the laser beam is sequentially reflected by the first scanning galvanometer and the second scanning galvanometer to reach the target object, thereby performing the film removal process on the target object.

### BRIEF DESCRIPTION OF THE DRAWINGS

The drawings described herein are intended to provide a further understanding of the present disclosure, are intended to be a part of the present disclosure, and are used to explain the technical solutions of the present disclosure with embodiments of the present disclosure, which do not constitute a limitation of the technical solutions of the present disclosure. In the drawing:
FIG. 1 is a schematic view showing a structure of a solar cell which is applied in some embodiments of the present disclosure.
FIG. 2 is a schematic view showing an apparatus for removing film and method for removing in the related art.
FIG. 3(a) is a schematic view showing a composition of the apparatus for removing film according to some embodiments of the present disclosure.
FIG. 3(b) is a schematic view showing a structure of an apparatus for removing film applied in a certain circumstance according to some embodiments of the present disclosure.
FIG. 4(a) is a schematic view showing a condition of an engraved line distortion on a solar cell.
FIG. 4(b) is a schematic view showing another condition of an engraved line distortion on a solar cell.
FIG. 4(c) is a schematic view showing a multiple-face splicing solution during the film removal process according to some embodiments of the present disclosure.
FIG. 5(a) is a schematic view showing a solution for a movement of a target object during a film removal process according to some embodiments of the present disclosure.
FIG. 5(b) is a schematic view showing a scanning path of the laser beam in the solution as shown in FIG. 5(a).
FIG. 6 is a flowchart of a processing method for removing film according to some embodiments of the present disclosure.
FIG. 7 is a flowchart of another processing method for removing film according to some embodiments of the present disclosure.
FIG. 8 is a flow chart of another processing method for removing film according to some embodiments of the present disclosure.

### DETAILED DESCRIPTION OF THE EMBODIMENTS

Embodiments of the present disclosure will be described in detail below with reference to the accompanying drawings. It should be noted that, in the case of no conflict, the features in the embodiments and the embodiments in the present disclosure may be arbitrarily combined with each other.

The steps illustrated in the flowcharts in the drawings may be performed in a computer system including a set of computer-executable instructions. Also, although logical sequences are shown in the flowcharts, in some cases the steps shown or described may be performed in a different order.

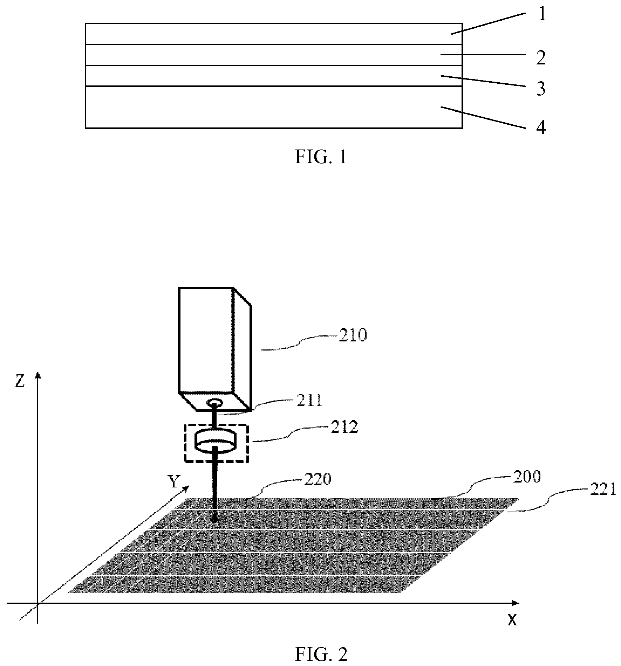

An apparatus for removing film and method for removing film according to some embodiments of the present disclosure can perform a film removal process on a target object. For example, a solar cell as shown in FIG. 1 is subjected to a film removal process. The solar cell includes a back electrode layer 1, a photovoltaic film layer 2, a front electrode layer 3, and a transparent substrate 4 in order. A general film removal process uses a laser to selectively etch the back electrode layer 1 and the photovoltaic film layer 2, or the back electrode layer 1, the photovoltaic film layer 2, and the front electrode layer 3.

A processing method for removing film of a solar cell in the related art is shown in FIG. 2. The solar cell 200 has cell structure engraved lines 221 parallel to an X-axis. This cell structure engraved lines 221 are inherent engraved lines on the solar cell 200, so a laser generator 210 does not need to perform a film removal process to obtain these cell structure engraved lines 221. Film removal engraved lines 220 parallel to a Y-axis on the solar cell 200 are required to be obtained through the film removal process performed by the laser generator 210. The specific processing method for removing film in the related art is as follows.

The laser generator 210 is fixed at a position where a laser beam emitted by the laser generator 210 is parallel to a Z-axis. That is, the laser generator 210 emits light in a fixed direction. The laser beam 211 generated by the laser generator 210 is focused by a focusing mirror 212. The solar cell 200 is grasped on a platform which is parallel to the XOY plane. This platform may drive the solar cell 200 in a direction parallel to the Y-axis by mechanical movement along the Y-axis to produce a film removal engraved line 220 parallel to the Y-axis. After producing a complete film removal engraved line 220 parallel to the Y-axis, if it is desired to generate another film removal engraved line 220 parallel to the Y-axis, it is necessary to drive the solar cell 200 to step through the mechanical movement of the platform along the X-axis, further, through the mechanical movement of the platform along the Y-axis, the solar cell 200 is driven to move in a direction parallel to the Y-axis to produce another film removal engraved line 220 parallel to the Y-axis.

The processing method for removing film in the related art is limited by the mechanical movement capability. an engraving velocity may only reach 1000-2000 mm/s, and a spot diameter or a spot width is generally limited to about 50 µm∼100 µm, so a film removal rate is lower. Further, in the laser film removal process in the related art, in order to increase the film removal rate, a plurality of laser heads are used for simultaneous processing. Due to the difference in performance of each laser, it is easy to generate a chromatic aberration or result in inconsistent spot diameters (or widths) in different processing areas. Inconsistent spot diameters (or widths) will result in inconsistent widths of the engraved lines, thereby affecting a subsequent processing, or affecting a film quality.

In the following, an apparatus for removing film and method for removing film according to some embodiments of the present disclosure will be mainly described by taking a film removal process of a solar cell as an example, that is, taking a target object as a solar cell chip as an example. It can be understood that the apparatus for removing film and method for removing film are applicable to various target objects that require film removal and marking.

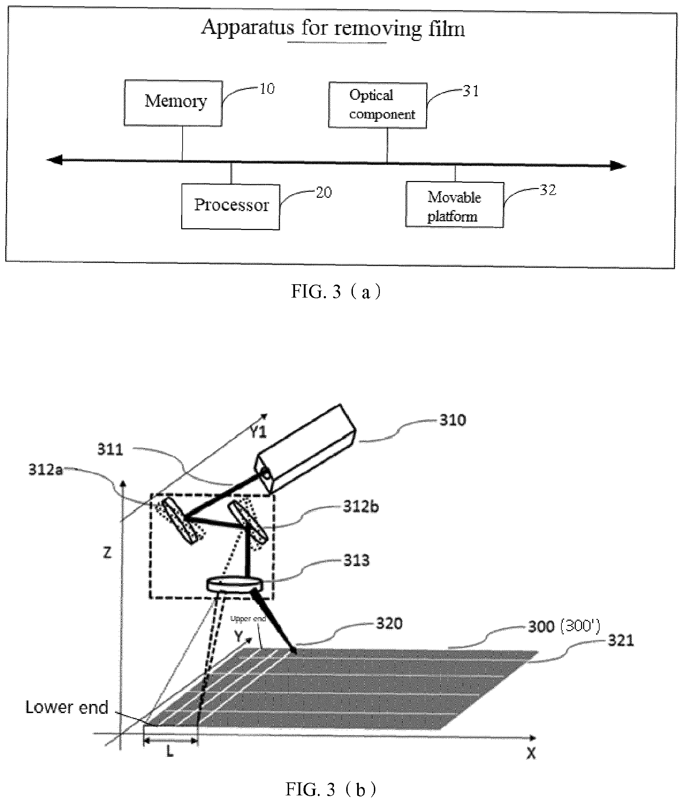

Referring to FIG. 3(a), some embodiments of the present disclosure provide an apparatus for removing film including an optical component 31, a memory 10, and a processor 20.

Referring to FIG. 3(b), the optical component 31 includes:
a laser generator 310 configured to generate a laser beam;
a first scanning galvanometer 312a configured to reflect a laser beam;
a second scanning galvanometer 312b configured to reflect the laser beam reflected by the first scanning galvanometer 312a.

That is, the optical assembly 31 includes a scanning galvanometer system including the first scanning galvanometer 312a and the second scanning galvanometer 312b. A scan rate of this scanning galvanometer system may be set as 0 ∼ 20000 mm/s.

The processor 20 is configured to control the laser generator 310 to generate a laser beam, and to control the first scanning galvanometer 312a and the second scanning galvanometer 312b to deflect, thereby performing a film removal process on the target object 300'.

The apparatus for removing film according to some embodiments of the present disclosure controls the laser beam irradiated on the target object 300' by the deflection control of the first scanning galvanometer 312a and the second scanning galvanometer 312b, thereby performing the film removal process on the target object 300'. Compared with the related art limited by the mechanical movement capability, the apparatus for removing film according to some embodiments of the present disclosure adopt a scanning galvanometer system having the first scanning galvanometer 312a and the second scanning galvanometer 312b, and can improve the engraving velocity and reduce the spot diameter, thereby greatly increasing the film removal rate of this apparatus and increasing a disposable processing area. Further, by using a single laser generator 310 in the apparatus for removing film, the problem of chromatic aberration can be improved.

For example, in some embodiments, when the apparatus for removing film is in use, the first scanning galvanometer 312a and the second scanning galvanometer 312b have a scan range of 0 x 0 mm to 1500 x 1500 mm, an engraved line velocity of 15000 mm/s, and a spot width (or diameter) of 1 mm. In this case, the film removal rate can reach 15000 mm²/s. However, in the related art, the apparatus for removing film is limited by the mechanical movement capability, the spot diameter usually does not exceed 100 µm, and the engraved line velocity does not exceed 1500 mm/s, so the film removal rate generally does not exceed 150 mm²/s. The velocity of the apparatus for removing film according to some embodiments of the present disclosure is 100 times faster than that of the apparatus for removing film of the related art.

In some embodiments of the present disclosure, the optical assembly 31 further includes a focusing mirror 313. The focusing mirror 313 is configured to focus the laser beam reflected by the second scanning galvanometer 312b to the target object 300' or to focus the laser beam generated by the laser generator 310 to the first scanning galvanometer 312a. The focus mirror may be used to adjust the diameter of the laser beam; and a laser beam unit energy can be increased to improve a film removal efficiency.

In some embodiments of the present disclosure, a focal length of the focusing mirror 313 is larger than or equal to a preset focal length. For example, the focusing mirror 313 is a focusing mirror of a type F825. A diameter of a laser beam focused at a focal length of the focus mirror of this model is larger than or equal to a preset diameter.

In some embodiments of the present disclosure, a beam diameter of the laser beam generated by the laser generator 310 is controlled such that the diameter of the laser beam irradiated on the target object is larger than or equal to a preset diameter. In some embodiments of the present disclosure, the diameter of the laser beam is controlled by the processor 20 or the focusing mirror 313.

In the apparatus for removing film, by making the diameter of the laser beam irradiated on the target object larger than or equal to a preset diameter, the number of times of film removal required to form an engraving line may be reduced when the apparatus for removing film is applied. That is, the film removal rate can be increased.

In some embodiments of the present disclosure, a power of the laser generator 310 is larger than or equal to a preset power. For example, the power of the laser generator 310 is several tens of W to several hundred W. For example, a green laser generator having a power of 100 W and a wavelength of 532 nm is used.

The film removal process is performed by using an apparatus for removing film with a laser generator having a larger power, and a possibility of removing the film by using a large spot is increased, which can further improve the film removal rate.

In some embodiments of the present disclosure, the apparatus for removing film further includes a memory 10 configured to store a film removal instruction of controlling the laser generator 310 to generate the laser beam and of controlling an occurrence a deflection of the first scanning galvanometer 312a and the second scanning galvanometer 312b to perform the film removal process on the target object 300'.

The processor 20 is configured to perform the film removal instruction stored in the memory 10.

In some embodiments of the present disclosure, before controlling the deflection of the first scanning galvanometer 312a and the second scanning galvanometer 312b, the processor 20 is further configured to control the target object 300' or the optical assembly 31 to move to a specified position.

Taking the target object 300' as the solar cell 300 as an example, moving the solar cell 300 or the optical component 31 to the specified position means moving the solar cell 300 or the optical component 31 to a position where the solar cell 300 and the optical component 31 satisfy a relative positional relationship. In this position, the film removal process for at least a portion of the solar cell 300 may be completed when the first scanning galvanometer 312a and the second scanning galvanometer 312b deflect.

In some embodiments of the present disclosure, when the target object is subjected to the film removal process, the film removal process may be performed according to a preset pattern of the film removal. The pattern of the film removal may be any pattern, for example, the pattern of the film removal may be a spot, an engraving line or other patterns, which is not limited in the present disclosure.

Hereinafter, a description will be given by taking the preset pattern of the film removal as the engraved line.

For example, in FIG. 3(b), in some practical applications where it is necessary to form an engraving line 320 parallel to the Y-axis, the memory 10 may store a film removal instruction which is performed by the processor 20, thereby completing the following configurations and operations. First, the first scanning galvanometer 312a and the second scanning galvanometer 312b are adjusted to a return-to-zero position, for example, a position where no deflection occurs. Then, the solar cell 300 or the optical component 31 is moved to a specified position so that the laser beam generated after the laser generator 310 is turned on may be focused to an upper end of a first film removal engraving line which is to be formed. Then, the laser generator 310 is controlled to turn on, the first scanning galvanometer 312a is controlled to remain stationary, and the second scanning galvanometer 312b is controlled to deflect, so that the laser beam is gradually scanned from an upper end to a lower end of the first film removal engraving line to be formed, thereby forming the first film removal engraving line. Thereafter, the laser generator 310 is controlled to turn off, the second scanning galvanometer 312b is controlled to remain stationary, and the first scanning galvanometer 312a is controlled to deflect, so that the laser beam generated after the laser generator 310 is turned on may be focused to a lower end of the second film removal engraving line to be formed. Then, the laser generator 310 is controlled to turn on, the first scanning galvanometer 312a is controlled to remain stationary, and the second scanning galvanometer 312b is controlled to deflect, so that the laser beam gradually moves from the lower end to an upper end of the second film removal engraving line to be formed, thereby forming the second film removal engraving line ..., and so on, a plurality of film removal engraving lines 320 are formed.

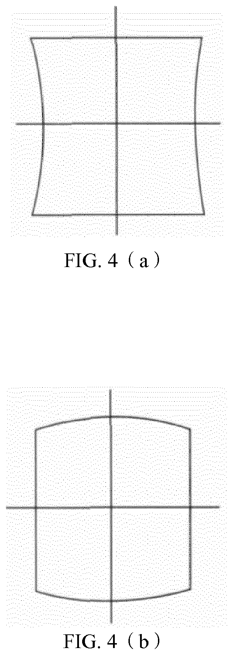

In the case where the deflection angle of the first scanning galvanometer 312a is large, an incident point of the laser beam on the second scanning galvanometer 312b may deviate from a central area of the second scanning galvanometer 312b, thereby distorting the film removal pattern. For example, the engraved line engraved on the solar cell is distorted. As shown in FIG. 4(a), in the case of engraving a line parallel to the Y-axis, two lines on an edge are not straight due to a deviation of the above incident point, thereby forming a "pincushion" distortion, and as shown in Fig. 4(b), in the case of engraving a line parallel to the x-axis, two lines on an edge are not straight due to the deviation of the above incident point, thereby forming a "barrel" distortion. In this way, the engraving lines are made non-parallel, thereby reducing the quality of the solar cell 300.

In order to improve the quality of the solar cell 300, in some embodiments of the present disclosure, the processor 20 is configured to control a deflection angle of the first scanning galvanometer 312a to be always less than or equal to a preset angle such that a distance between an incident point of the laser beam on the first scanning galvanometer 312a and a geometric center point of the first scanning galvanometer 312a is less than or equal to a first preset distance, and a distance between an incident point of the laser beam on the second scanning galvanometer 312b and a geometric center point of the second scanning galvanometer 312b is less than or equal to a second preset distance.

In this case, the galvanometer system has a scan range no larger than its web range. The web range refers to a maximum range that can be scanned when a pattern is formed by the deflection of the first scanning galvanometer 312a and the second scanning galvanometer 312b and the pattern is not distorted in the case where the galvanometer system does not move.

In the case where a film removal range of the target object 300' is larger than the web range of the galvanometer system, in some embodiments of the present disclosure, the memory 10 stores a film removal instruction of splicing multiple-faces and the film removal instruction is performed by the processor 20. The target object 300' is divided into a plurality of preset areas, each of which is smaller than or equal to the scanning range of the first scanning galvanometer 312a and the second scanning galvanometer 312b. The processor 20 is configured to perform the film removal process on each of the preset areas, that is, to perform the film removal process on the first preset area, after the completion thereof, to perform the film removal process on the second preset area, after the completion thereof, to perform the film removal process on the third preset areas, ..., and so on, until the film removal process on all the preset areas is completed.

The following is an example of a multiple faces splicing being in the X direction, and the target object 300' being the solar cell 300. The solar cell 300 is first divided into a plurality of preset areas, and a side length of each of the preset areas in the X direction is less than or equal to the scanning range of the first scanning galvanometer 312a. Then, each of the preset areas is subjected to a film removal process, that is, the first preset area is subjected to the film removal process; after the completion thereof, the second preset area is subjected to the film removal process; after the completion thereof, the third preset area is subjected to the film removal process, ..., and so on, until the film removal process on all preset areas is completed.

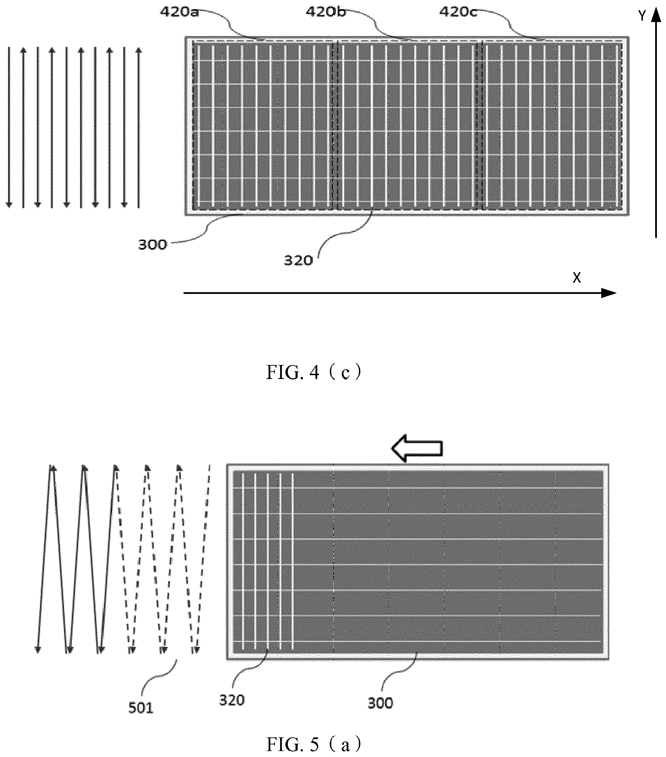

As shown in FIG. 4(c), in some embodiments of the present disclosure, it is necessary to engrave 30 film removal engraving lines 320 parallel to the Y-axis on the solar cell 300.

The memory 10 may store a film removal instruction which is performed by the processor 20, thereby completing the following configurations and operations. An area where a film is to be removed of the solar cell is divided into three preset areas along the X direction, which are a preset area 420a, a preset area 420b, and a preset area 420c, respectively. Ten engraved lines 320 parallel to the Y-axis will be engraved in the preset area 420a, the preset area 420b, and the preset area 420c, respectively. First, the first scanning galvanometer 312a and the second scanning galvanometer 312b are adjusted to the return-to-zero position. Then, the solar cell 300 or the optical component 31 is moved to a specified position, so that the laser beam generated after the laser generator 310 is turned on may be focused to an upper end of a first film removal engraved line to be formed in the preset area 420a. Then, the laser generator 310 is controlled to turn on to generate the laser beam, the first scanning galvanometer 312a is controlled to remain stationary, and the second scanning galvanometer 312b is controlled to deflect, so that the laser beam gradually moves from the upper end to the lower end of the first film removal engraved line to be formed, thereby forming the first film removal engraved line. Thereafter, the laser generator 310 is controlled to turn off, the second scanning galvanometer 312b is controlled to remain stationary, and the first scanning galvanometer 312a is controlled to deflect, so that the laser beam may be focused to a lower end of the second film removal engraved line to be formed after the laser generator 310 is turned on. Then, the laser generator 310 is controlled to turn on, the first scanning galvanometer 312a is controlled to remain stationary, and the second scanning galvanometer 312b is controlled to deflect, so that the laser beam gradually moves from the lower end to the upper end of the second film removal engraved line to be formed, thereby forming the second film removal engraved line..., and so on, 10 film removal engraved lines 320 in the preset area 420a are formed.

Then, the solar cell 300 or the optical component 31 is moved to a next specified position, and 10 film removal engraved lines are formed in the preset area 420b in the above-described manner. 10 film removal engraved lines are formed in the preset area 420c in the same step.

Through the multiple-face splicing method described above, the apparatus for removing film may complete the film removal process of the entire solar cell 300 in the case where the deflection angle of the first scanning galvanometer 312a is controlled to be less than or equal to the preset angle, thereby improving the quality of the film removal process.

In addition to the multiple-face splicing method described above, further solutions are provided in some embodiments such that the deflection angle of the first scanning galvanometer 312a is always less than or equal to the preset angle during the film removal process. In some embodiments of the present disclosure, as shown in FIG. 3(a), the apparatus for removing film further includes a movable platform 32.

The movable platform 32 is configured to carry the target object 300' to drive the target object 300' to move.

In some embodiments of the present disclosure, the memory 10 is configured to store a movement instruction of controlling a movement of the movable platform 32; and the processor 20 is further configured to perform the movement instruction to move the movable platform 32.

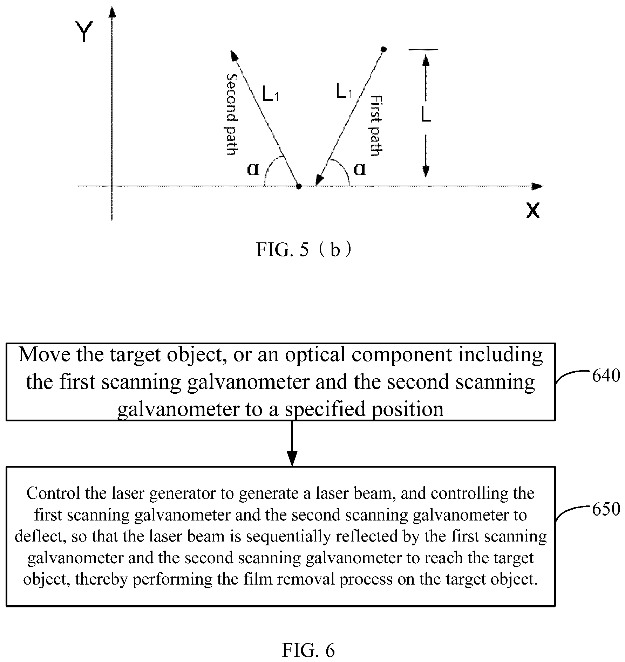

Applying the apparatus for removing film according to the above embodiments, it is possible to drive the target object to move by controlling the movable platform 32 during the film removal process. Thus, even in the case where a multiple-face splicing is not employed, it is ensured that the deflection angle of the first scanning galvanometer 312a is always less than or equal to the preset angle. Also, the quality of the film is improved. Referring to FIG. 3(b), FIG. 5(a) and FIG. 5(b), in some practical embodiments, in order to obtain a film removal engraved line 320 parallel to the Y-axis, the memory 10 may store a film removal instruction and a movement instruction which are performed by the processor 20, thereby completing the following configuration and operations. Controlling the laser generator 310 to turn on, and controlling the first scanning galvanometer 312a and the second scanning galvanometer 312b to deflect such that the laser beam irradiating the solar cell 300 is in a first path inclined to the X-axis with respect to the XOY plane to scan. At the same time, the movable platform 32 is controlled to drive the solar cell 300 to move at a constant velocity along the -X axis as shown in FIG. 5(a). The scanning velocity v1 of the laser beam with respect to the XOY plane may be regarded as a combined velocity of a velocity v₋ₓ along the -X axis and a velocity v_{-y} along the -Y axis. A velocity that the moving platform 32 drives the solar cell 300 along the -X axis is v₃, and satisfies v₋ₓ = v₃. That is, with respect to the solar cell 300, the velocity at which the laser beam is engraved in the direction of the -X axis is 0, and the velocity at which the laser beam is engraved in the -Y axis direction is v_{-y}. Thus, an engraved line 320 parallel to the Y-axis is obtained on the solar cell 300.

It is known that the first path described above is a scanning path of the laser beam with respect to the XOY plane. The angle α between the first path and the X-axis satisfies sin α=L/L1, where L is a length of the engraved line on the solar cell and L1 is a length of the first path.

To engrave the next engraved line, the laser generator 310 is controlled to be turned off first. During the turnoff of the laser generator 310, the movable platform 32 is controlled to drive the solar cell 300 to continue to move at a constant velocity along the -X axis. A duration during which the laser generator 310 is turned off is W/v₃ (W is a distance between two adjacent engraved lines). Then, the laser generator 310 is controlled to turn on, and the first scanning galvanometer 312a and the second scanning galvanometer 312b are controlled to deflect such that the laser beam irradiating the solar cell 300 is in a second path inclined to the -X axis in relative to the XOY plane to scan. At this time, a scanning velocity v₂ of the laser beam with respect to the XOY plane may be regarded as the combined velocity of the velocity v₋ₓ along the -X axis and the velocity v_{y} along the Y-axis (v_{y} and v_{-y} have the same magnitude and opposite direction) and satisfies v₋ₓ = v₃. That is, with respect to the solar cell 300, the velocity at which the laser beam is engraved in the direction of the -X axis is 0, and the velocity at which the laser beam is engraved in the Y-axis direction is v_{y}. Thus, another engraved line 320 parallel to the Y-axis is obtained on the solar cell 300. Further, as shown in FIG. 5(b), an angle between the second path and the -X axis is equal to the angle between the first path and the X-axis, and is also α.

Next, the laser generator 310 is controlled to turn off, and during the turn off of the laser generator 310, the movable platform 32 is controlled to drive the solar cell 300 to continue to move at a constant velocity along the -X axis. A duration which the laser generator 310 is turned off is W/v₃. The process of engraving the two engraving lines is continued to complete the film removal process of the solar cell 300.

Further, in the above process, during the turn off of the laser generator 310, the processor 20 controls the first scanning galvanometer to return to zero, so as to ensure that the deflection angle of the first scanning galvanometer is always less than or equal to the preset angle during the film removal process.

It should be noted that, in the case where a power of the laser generator 310 is less than a preset power, or a diameter of the laser beam irradiated on the solar cell 300 is smaller than a preset diameter, optionally, one engraved line is engraved more than once.

In the case of engraving twice, after the scanning of the first path is completed, the control laser generator 310 is not turned off, the scanning direction of the second scanning galvanometer 312b is directly adjusted, and the first scanning galvanometer 312a and the second scanning galvanometer 312 are controlled to deflect to perform a second path, thereby forming two sub-engraved lines completely coincided or partially coincided in the width direction as one engraving line. Then, the laser generator 310 is controlled to turn off, and after the solar cell 300 is moved at a constant velocity along the -X axis for a period of W/v₃, the process of forming the two sub-engraved lines completely coincided or partially coincided in the width direction is continued to form another engraved line.

With a similar configuration and operation, one engraved line may be formed by engraving three, four, or even more times.

Some embodiments of the present disclosure provide an apparatus for removing film capable of controlling the first scanning galvanometer and the second scanning galvanometer to deflect in use, controlling a movement of the target object to perform scanning film removal process on the target object, and further ensuring that the deflection angle of the first scanning galvanometer 312a during the film removal process be always less than or equal to the preset angle. Thus, the disposable processing area can be increased, and the film removal rate and the film removal quality can be improved. Moreover, the use of a single laser generator can increase the film removal rate and improve the chromatic aberration.

Referring to FIG. 6, some embodiments of the present disclosure provide a processing method for removing film using the apparatus for removing film as described in the above embodiments. The processing method for removing film includes the following step 650 (S650).

S650, controlling the laser generator 310 to generate a laser beam, and controlling the first scanning galvanometer 312a and the second scanning galvanometer 312b to deflect, so that the laser beam is sequentially reflected by the first scanning galvanometer 312a and the second scanning galvanometer 312b to reach the target object, thereby performing the film removal process on the target object.

For example, in some embodiments, the first scanning galvanometer 312a and the second scanning galvanometer 312b have a scan range of 0x0 mm to 1500 x 1500 mm, an engraving velocity of 15000 mm/s, and a spot width (or diameter) of 1 mm. In this case, a film removal rate can reach 15000 mm²/s. In a processing method for removing film of the related art, when a spot diameter is 100 µm and an engraving velocity is 1500 mm/s, a film removal rate is 150 mm²/s. Therefore, the processing method for removing film of some embodiments of the present disclosure is more than 100 times faster than the processing method for removing film in the related art.

In some embodiments of the present disclosure, a scanning galvanometer system having the first scanning galvanometer 312a and the second scanning galvanometer 312b is used in the processing method for removing film, which can greatly increase the film removal rate, thereby increasing a disposable processing area. Moreover, the use of a single laser generator 310 can increase the film removal rate and improve the problem of chromatic aberration.

In some embodiments of the present disclosure, the target object is a solar cell 300.

In some embodiments of the present disclosure, S640 is also included before S650.

S640, moving the target object, or an optical component 31 including the first scanning galvanometer 312a and the second scanning galvanometer 312b to a specified position.

It can be understood that when the target object (for example, the solar cell 300) is subjected to the film removal process, the pattern of the film removal may be any pattern. For example, the pattern of the film removal may be a spot, or an engraving line, or other patterns, which is not limited in the embodiment of the present disclosure.

In some of the following embodiments, the engraved line will be mainly described as an example.

In some embodiments, as shown in FIG. 3(b), a film removal engraved line 320 parallel to the Y-axis needs to be formed on the solar cell 300. At this time, the processing method for removing film includes the following steps 701-707 (S701-S707).

S701, adjusting the first scanning galvanometer 312a and the second scanning galvanometer 312b to a return-to-zero position.

S702, moving the solar cell 300 or the optical component 31 to a specified position, so that the laser beam generated after the laser generator 310 is turned on may be focused to an upper end of the first film removal engraved line to be formed.

S703, controlling the laser generator 310 to turn on, controlling the first scanning galvanometer 312a to remain stationary, and controlling the second scanning galvanometer 312b to deflect, so that the laser beam is gradually scanned from the upper end to a lower end of a first film removal engraved line to be formed, thereby forming the first film removal engraved line.

S704, controlling the laser generator 310 to turn off, controlling the second scanning galvanometer 312b to remain stationary, and controlling the first scanning galvanometer 312a to deflect, so that the laser beam generated after the laser generator 310 is turned on may be focused to a lower end of a second film removal engraved line to be formed.

S705, controlling the laser generator 310 to turn on, controlling the first scanning galvanometer 312a to remain stationary, and controlling the second scanning galvanometer 312b to deflect, so that the laser beam is gradually moved from the lower end to an upper end of the second film removal engraved line to be formed, thereby forming the second film removal engraved line 320.

S706, controlling the laser generator 310 to turn off, controlling the second scanning galvanometer 312b to remain stationary, and controlling the first scanning galvanometer 312a to deflect, so that the laser beam generated after the laser generator 310 is turned on may be focused to an upper end of a third film removal engraved line to be formed.

S707, continuing to perform the above S703-S706 to form a plurality of film removal engraved lines 320. After forming a preset number of film removal engraved lines 320, the step is stopped, for example, stopped after S703 or S705 is performed.

The above-described "first", "second", and "third" are merely intended to distinguish the various steps and are not intended to be limiting. For example, when S703 is subsequently performed after S706, "the third film removal engraved line to be formed" in S706 is the "the first film removal engraved line to be formed" in S703 which is subsequently performed.

As discussed above, in some embodiments in which the film removal range of the target object exceeds the web range of the galvanometer system, when the deflection angle of the first scanning galvanometer 312a in the optical assembly 31 is large, the pattern of film removal is caused to be distorted, which reduces the quality of the film removal. For this problem, in some embodiments, the processing method for removing film further includes: controlling the deflection angle of the first scanning galvanometer 312a to be always less than or equal to the preset angle.

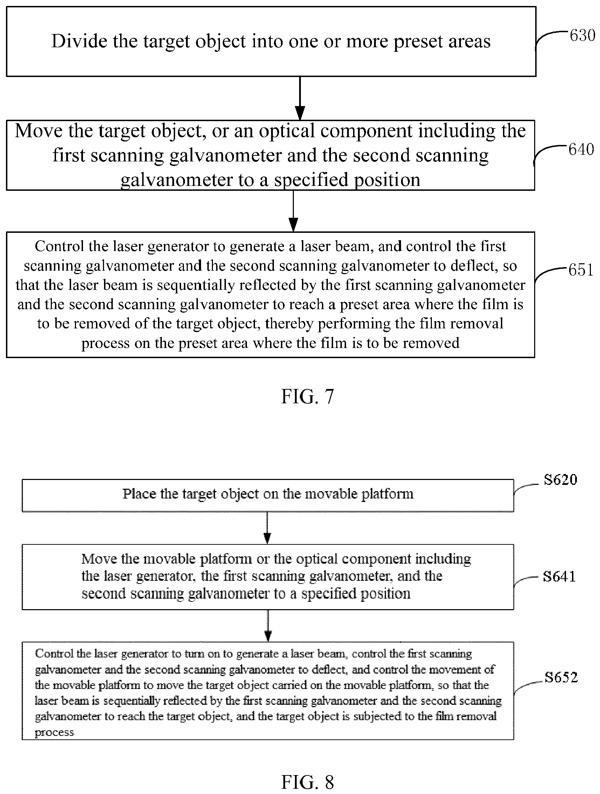

As shown in FIG. 7, in some embodiments of the present disclosure, in order that the film removal process of the entire target object is completed in the case where the deflection angle of the first scanning galvanometer 312 is controlled to be less than or equal to the preset angle, the method also includes step 630 (S630).

S630, dividing the target object into one or more preset areas.

Each of the preset areas is less than or equal to the web range of the first scanning galvanometer 312a and the second scanning galvanometer 312b, i.e., the web range of the galvanometer system. Each of the preset areas is subjected to the film removal process respectively. That is, a first preset area is subjected to the film removal process, and after the completion thereof, a second preset area is subjected to the film removal process, and after the completion thereof, a third preset area is subjected to the film removal process, ..., and so on, until the film removal process on all preset areas is completed. In these embodiments, the above step 650 is performed in each of the preset areas divided in the above S630. As shown in FIG. 7, for each of the preset areas where film is to be removed of the target object, S650 is performed in the manner of S651 described below.

S651, controlling the laser generator 310 to generate a laser beam, and controlling the first scanning galvanometer 312a and the second scanning galvanometer 312b to deflect, so that the laser beam is sequentially reflected by the first scanning galvanometer 312a and the second scanning galvanometer 312b to reach a preset area where the film is to be removed of the target object, thereby performing the film removal process on the preset area where the film is to be removed.

That is, the film removal method by the web splicing improves the problem of the film removal pattern distortion and improves the film removal quality.

For example, as shown in FIG. 4(c), in some embodiments of the present disclosure, it is necessary to engrave 30 film removal engraved lines 320 parallel to the Y-axis on the solar cell 300. At this time, the processing method for removing film includes the following steps 801 to 804 (S801-S804).

S801, dividing the area of the solar cell to be removed film into three preset areas in the X direction, respectively being a preset area 420a, a preset area 420b, and a preset area 420c.

S802, performing the above S701-S707 to form 10 film removal engraved lines in the preset area 420a.

S803, performing S701-S707 described above, forming 10 film removal engraved lines in the preset area 420b.

S804, performing S701-S707 described above, forming 10 film removal engraved lines in the preset area 420c.

In addition to the above-described multiple-face splicing manner, further solutions are provided in some embodiments such that the deflection angle of the first scanning galvanometer 312a is always less than or equal to the preset angle during the film removal process. In some embodiments, the processing method for removing film further includes: controlling the movement of a movable platform 32 while controlling the laser generator 310 to generate a laser beam and controlling the first scanning galvanometer 312a and the second scanning galvanometer 312b to deflect, such that the target object carried on the movable platform is moved. That is, as shown in FIG. 8, S650 is performed in the manner of the following step 652 (S652).

S652, controlling the laser generator 310 to turn on to generate laser beam, controlling the first scanning galvanometer 312a and the second scanning galvanometer 312b to deflect, and controlling the movement of the movable platform 32 to move the target object carried on the movable platform 32, so that the laser beam is sequentially reflected by the first scanning galvanometer 312a and the second scanning galvanometer 312b to reach the target object, and the target object is subjected to the film removal process.

As shown in FIG. 8, in some embodiments, the processing method for removing film further includes step 620 (S620).

S620, placing the target object on the movable platform 32.

As shown in FIG. 8, in some embodiments, S640 is performed in the manner of S641 described below.

S641, moving the movable platform 32 or the optical component 31 including the laser generator 310, the first scanning galvanometer 312a, and the second scanning galvanometer 312b to a specified position.

In some embodiments of the present disclosure, the processing method for removing film includes: in the above S652, the scanning velocity of the laser beam reaching the target object through the first scanning galvanometer 312a and the second scanning galvanometer 312b is v₁, and a component of the v₁ in the direction of the movement of the target object is the same as a velocity of the movement of the target object.

In some embodiments of the present disclosure, a scanning film removal process is achieved by controlling the movable platform 32 to drive the target object during the film removal process. Thus, even in the case where the multiple-face splicing is not employed, it is ensured that the deflection angle of the first scanning galvanometer 312a is always less than or equal to the preset angle. The film removal rate and the film removal quality are improved.

In some embodiments of the present disclosure, referring to FIG. 3(b), FIG. 5(a), and FIG. 5(b), it is necessary to engrave the film removal engraved line 320 on the solar cell 300. The processing method for removing film includes the following steps 901-907, and S9040 (S901-S907, S9040).

S901, placing a solar cell 300 on the movable platform 32.

S902, moving the movable platform 32 or the optical component 31 including the laser generator 310, the first scanning galvanometer 312a, and the second scanning galvanometer 312b to a specified position.

S903, controlling the laser generator 310 to turn on and controlling the first scanning galvanometer 312a and the second scanning galvanometer 312b to deflect, so that the laser beam irradiating the solar cell 300 is in a first path inclined to the X-axis with respect to the XOY plane to scan; and controlling the movable platform 32 at the same time to drive the solar cell 300 to move at a constant velocity along the -X axis as shown in FIG. 5(a).

A scanning velocity v₁ of the laser beam with respect to the XOY plane may be regarded as a combined velocity of a velocity v₋ₓ along the -X axis and a velocity v_{-y} along the -Y axis. A velocity of the moving platform 32 driven by the solar cell 300 along the -X axis is v₃, and satisfies v_{-X} = v₃. That is, with respect to the solar cell 300, a velocity at which the laser beam engraves in the direction of the -X axis is 0, and a velocity at which the laser beam engraves in the -Y-axis direction is v_{-y}. Thus, an engraved line parallel to the Y-axis is obtained on the solar cell 300.

It is known that the first path described above is a scanning path of the laser beam with respect to the XOY plane. An angle α between the first path and the X-axis satisfies sin α=L/L₁, where L is a length of the engraved line on the solar cell and L1 is a length of the first path.

S904, controlling the laser generator 310 to turn off, and during the turn off of the laser generator 310, controlling the movable platform 32 to drive the solar cell 300 to continue to move at a constant velocity along the -X axis. A duration of the laser generator 310 being turned off is W/v₃, where W is a distance between two adjacent engraved lines.

S905, controlling the laser generator 310 to turn on, and controlling the first scanning galvanometer 312a and the second scanning galvanometer 312b to deflect, so that the laser beam illuminating the solar cell 300 is in a second path inclined to the X-axis relative to the XOY plane to scan.

At this time, a scanning velocity v₂ of the laser beam with respect to the XOY plane may be regarded as a combined velocity of a velocity v₋ₓ along the -X axis and a velocity v_{y} along the Y axis (v_{y} and v_{-y} have the same magnitude and opposite direction), and satisfies v₋ₓ = v₃. That is, with respect to the solar cell 300, a velocity at which the laser beam engraves in the direction of the -X axis is 0, and a velocity at which the laser beam engraves in the Y-axis direction is v_{y}. Thus, another engraved line parallel to the Y-axis is obtained on the solar cell 300. Further, as shown in FIG. 5(b), an angle between the second path and the -X axis is equal to the angle between the first path and the X-axis, and is also α.

S906, controlling the laser generator 310 to turn off, and during the turn off of the laser generator 310, controlling the movable platform 32 to drive the solar cell 300 to continue to move at a constant velocity along the -X axis, and the duration of the laser generator 310 being turned off is W/v₃.

S907, continuing the above S903-S906 to perform the film removal process on the solar cell 300. After a preset number of film removal engraved lines are formed, the film removal process is stopped, for example, stopped after the performance of S903 or S905.

Further, in the above process, at least some of the periods during which the laser generator 310 is turned off, the following step 9040 is performed (S9040).

S9040, controlling the first scanning galvanometer 312a to return to zero to ensure that the deflection angle is always less than or equal to the preset angle during the film removal process.

It should be noted that, in the case where the power of the laser generator 310 is less than the preset power, or the diameter of the laser beam irradiated on the solar cell 300 is smaller than the preset diameter, optionally, an engraved line is engraved more than once.

In some embodiments in which the engraving is performed twice, after S903, S904 is not performed, instead of performing S904' described below, and then S905 is performed.

S904', adjusting a scanning direction of the second scanning galvanometer 312b.

Through the above steps, two sub-engraved lines completely coincided or partially coincided in the width direction are formed as an engraved line.

Proceeding to S906 and S907' below.

S907', continuously performing S903, S904', S905, and S906 to perform the film removal process on the solar cell 300. After a preset number of film removal engraved lines are formed, the film removal process is stopped, for example, it is stopped after the performance of S905.

With a similar configure, an engraved line may be formed by scanning three times, four times, or even more times.

In some embodiments of the present disclosure, the processing method for removing film further includes: controlling a power when the laser generator is turned on to be larger than or equal to a preset power.

Using a higher power laser generator, the film removal rate is fast. Moreover, a plurality of film removal engraved lines may be quickly formed using a single laser head, which improves the chromatic aberration problem.

In some embodiments of the present disclosure, the processing method for removing film further includes: controlling a diameter of the laser beam irradiated on the target object to be larger than or equal to a preset diameter.

By controlling the diameter of the laser beam irradiated on the target object to be larger than or equal to the preset diameter, the number of times of film removal forming one engraving line can be reduced. That is, the film removal rate is increased.

The embodiments disclosed in the present disclosure are as described above, but are merely used to facilitate the understanding of the present disclosure, and are not intended to limit the present disclosure. Any modification and variation in the form and details of the implementation may be made by those skilled in the art without departing from the spirit and scope of the disclosure. The scope defined by the appended claims shall prevail.

## Claims

1. An apparatus for removing film comprising an optical component (31) and a processor (20), wherein
the optical component (31) includes:
a laser generator (210) configured to generate a laser beam;
a first scanning galvanometer (312a) configured to reflect the laser beam; and
a second scanning galvanometer (312b) configured to reflect the laser beam reflected by the first scanning galvanometer (312a);
wherein the processor (20) is configured to control the laser generator (210) to generate the laser beam, and to control the first scanning galvanometer (312a) and the second scanning galvanometer (312b) to deflect, thereby performing a film removal process on a target object (300').

2. The apparatus for removing film according to claim 1, wherein
before controlling the first scanning galvanometer (312a) and the second scanning galvanometer (312b) to deflect, the processor (20) is further configured to control the target object (300') or the optical component (31) to move to a specified position.

3. The apparatus for removing film according to claim 2, wherein
the apparatus for removing film further includes a movable platform (32) configured to carry the target object (300'); and
the processor (20) is also configured to control a movement of the movable platform (32) to drive a movement of the target object (300').

4. The apparatus for removing film according to any one of claims 1 to 3, wherein the apparatus for removing film further includes a memory (10), the memory (10) is configured to store a film removal instruction of controlling the laser generator (210) to generate a laser beam, and of controlling the first scanning galvanometer (312a) and the second scanning galvanometer (312b) to deflect, thereby performing the film removal process on the target object (300'); and
the processor (20) is configured to perform the film removal instruction.

5. The apparatus for removing film according to claim 3, wherein the apparatus for removing film further includes: a memory (10) configured to store a movement instruction of controlling the movement of the movable platform (32); and
the processor (20) is configured to perform the movement instruction.

6. The apparatus for removing film according to claim 5, wherein the memory (10) is further configured to store to a film removal instruction of controlling the laser generator (210) to generate a laser beam, and of controlling the first scanning galvanometer (312a) and the second scanning galvanometer (312b) to deflect, thereby performing the film removal process on the target object (300'); and
the processor (20) is configured to perform the film removal instruction.

7. The apparatus for removing film according to any one of claims 1 to 6, wherein the optical component (31) further includes:
a focusing mirror (212) configured to focus the laser beam reflected by the second scanning galvanometer (312b) to the target object (300') or to focus the laser beam generated by the laser generator (210) to the first scanning galvanometer (312a).

8. The apparatus for removing film according to claim 7, wherein a focal length of the focusing mirror (212) is larger than or equal to a preset focal length.

9. The apparatus for removing film according to any one of claims 1 to 8, wherein the apparatus for removing film is configured to control a diameter of the laser beam generated by the laser generator (210) such that the diameter of the laser beam irradiated on the target object (300') is larger than or equal to a preset diameter.

10. The apparatus for removing film according to any one of claims 1 to 9, wherein the processor (20) is configured to control a deflection angle of the first scanning galvanometer (312a) to be less than or equal to a preset angle.

11. The apparatus for removing film according to any one of claims 1 to 10, wherein the target object (300') includes one or more preset areas, each of which is smaller than or equal to a scanning range of the first scanning galvanometer (312a) and the second scanning galvanometer (312b); and the processor (20) is configured to perform the film removal process on each of the preset areas of the target object (300') respectively.

12. A processing method for removing film applying the apparatus for removing film according to any one of claims 1 to 11, the method comprising:
controlling the laser generator (210) to generate a laser beam, and controlling the first scanning galvanometer (312a) and the second scanning galvanometer (312b) to deflect, so that the laser beam is sequentially reflected by the first scanning galvanometer (312a) and the second scanning galvanometer (312b) to reach the target object (300'), thereby performing the film removal process on the target object (300').

13. The processing method for removing film according to claim 12, wherein the method further includes:
dividing the target object (300') into one or more preset areas, wherein each preset area is smaller than or equal to a scanning range of the first scanning galvanometer (312a) and the second scanning galvanometer (312b);
for each of the preset areas where the film is to be removed of the target object (300'), the film removal process is performed as follows:
controlling the laser generator (210) to generate a laser beam, and controlling the first scanning galvanometer (312a) and the second scanning galvanometer (312b) to deflect such that the laser beam is sequentially reflected by the first scanning galvanometer (312a) and the second scanning galvanometer (312b) to reach a preset area where the film is to be removed of the target object (300'), thereby performing the film removal process on the preset area where film is to be removed.

14. The processing method for removing film according to claim 12 or 13, wherein before controlling the laser generator (210) to generate a laser beam and controlling the first scanning galvanometer (312a) and the second scanning galvanometer (312b) to deflect, the method further includes:
moving the target object (300') or an optical component (31) including the laser generator (210), the first scanning galvanometer (312a), and the second scanning galvanometer (312b) to a specified position.

15. The processing method for removing film according to claim 14, wherein, while controlling the laser generator (210) to generate a laser beam and controlling the first scanning galvanometer (312a) and the second scanning galvanometer (312b) to deflect, the method further includes:
moving the movable platform (32) to move the target object (300') carried on the movable platform (32).
